# EUROPÄISCHE PATENTSCHRIFT

(11) **EP 0 340 506 B1**
(45) Veröffentlichungstag und Bekanntmachung des Hinweises auf die Patenterteilung: **02.02.1994**
(21) Anmeldenummer: 89106682.1
(22) Anmeldetag: 14.04.1989
(51) Int. Cl.: H01L 21/00, B23K 20/00

(54) **Vorrichtung zur ultraschallkontaktierenden Drahtverbindung an elektronischen Komponenten**
Device for an ultrasonically contacting wire connection to electronic components
Dispositif de connexion par fils de contact par ultrasons à des composants électroniques

(30) Priorität: 05.05.1988 CH 1704/88; 05.05.1988 CH 1705/88; 28.12.1988 CH 4814/88
(43) Veröffentlichungstag der Anmeldung: 08.11.1989
(73) Patentinhaber: ESEC SA, CH-6330 Cham (CH)
(72) Erfinder: Thürlemann, Silvan, CH-6332 Hagendorn (CH); Meisser, Claudio, CH-6330 Cham (CH); Eggenschwiler, Hans, CH-6312 Steinhausen (CH)
(74) Vertreter: EGLI-EUROPEAN PATENT ATTORNEYS

(56) Entgegenhaltungen:
- EP-A- 0 186 176
- US-A- 4 610 387
- US-A- 4 653 681

## Beschreibung

Die Erfindung bezieht sich auf eine Vorrichtung zur ultraschallkontaktierenden Drahtverbindung von Schaltkreisen an elektronischen Komponenten mittels eines Kontaktierorgans, welches einen von einem elektromotorischen Antrieb um eine Achse schwenkbaren ersten Tragrahmen sowie einen daran angeordneten und zur Aufnahme eines mit einer Kapillare versehenen Energie-Transducers ausgebildeten zweiten Tragrahmen umfasst, wobei der zweite Tragrahmen an einer im Abstand zur Achse angeordneten Gelenkstelle des ersten Tragrahmens gelagert und beim Kontakt der Kapillare mit der jeweiligen elektronischen Komponente relativ zum ersten Tragrahmen beweglich ist.

Aus der EP-A 0 186 176 ist eine Vorrichtung zum Befestigen von Verbindungsdrähten an den Anschlussstellen eines Halbleiterbauelements bekannt, welche Vorrichtung im wesentlichen einen um eine erste Achse schwenkbaren Tragrahmen und einen mit Zapfen in dem Tragrahmen um eine zweite Achse schwenkbar gelagerten Halteblock umfasst, an welchem ein Auslegerarm . (Transducer) mit Kapillare sowie an Anschlagarm angeordnet sind, wobei der am Halteblock angeordnete Anschlagarm zwischen einem ersten Anschlag des Tragrahmens und einem zugeordneten zweiten Anschlag eines piezoelektrischen Antriebs angeordnet ist und durch die Kraft einer am Halteblock sowie am Tragarm gelagerten Feder auf den ersten Anschlag gedrückt wird, während bei Erregung des piezoelektrischen Antriebs zwischen den beiden Anschlägen ein Spiel für den Anschlagarm erzeugt wird. Bei dieser Vorrichtung wird der am Anschlussfleck des Halbleiterbauelements wirkende Schweissdruck durch die Kraft der Feder erreicht und bestimmt, wobei mit dem Anschlag des piezoelektrischen Antriebs lediglich festgestellt werden kann, ob der Anschlagarm vom Anschlag (touch down) abgehoben hat.

Aus der US-A 4 610 387 ist eine Kontaktiervorrichtung zum Ultraschall-Drahtschweissen bekannt, welche im wesentlichen einen ersten, einen zweiten sowie einen dritten, jeweils etwa gabelartig ausgebildeten Tragrahmen umfasst. Der an einem Hauptträger angeordnete und mit einem ersten Motor und entsprechend zugeordneter Kurbel in Wirkverbindung stehende erste Tragrahmen ist zusammen mit den beiden, daran um eine gemeinsame Achse schwenkbar gelagerten zweiten und dritten Tragrahmen relativ zu dem Hauptträger etwa in vertikaler Richtung, dass heisst, in Richtung zugeordneter, elektronischer Komponenten (Chips) verstellbar. Der dritte Tragrahmen ist mit einem weiteren, als Linearmotor ausgebildeten zweiten Motor wirkverbunden und der zweite Tragrahmen zur Aufnahme eines an seinem vorderen Ende mit einer Kapillare versehenen Energiewandlers (Transducer) ausgebildet. An dem zweiten und dritten Tragrahmen, welche relativ zueinander bewegbar sind, sind jeweils korrespondierend zueinander angeordnete Kontakte vorgesehen, welche in einer ersten Phase von einem etwa am zweiten Tragrahmen wirkenden Elektromagneten in Eingriff gebracht werden.

Der Erfindung liegt die Aufgabe zugrunde, eine Vorrichtung der erwähnten Gattung dahingehend zu verbessern und derart auszubilden, dass für die Drahtverbindung von Schaltkreisen an elektronischen Komponenten eine exakte Zustellbewegung der beiden Tragrahmen zusammen mit dem Energie-Transducer gewährleistet ist, ohne dass bei der gemeinsamen Schwenkbewegung eine Relativbewegung des mit dem Energie-Transducers versehenen Tragrahmens in Bezug zu dem anderen Tragrahmens erfolgt.

Diese Aufgabe wird erfindungsgemäss dadurch gelöst, dass die beiden Tragrahmen sowie der Energie-Transducer in einem Trägerelement um die Achse schwenkbar angeordnet sind und einen gemeinsamen, auf der Symmetrieachse der einzelnen Teile liegenden Massenschwerpunkt aufweisen, und dass der Massenschwerpunkt innerhalb eines senkrecht zur Achse orientierten und mit seinem Zentrum auf einer zwischen der Achse und der Gelenkstelle gebildeten und ebenfalls senkrecht zur Achse orientierten Geraden angeordneten Kreises liegt, dessen Radius kleiner als die Hälfte des Abstandes zwischen der Achse und der Gelenkstelle ist.

Bei der erfindungsgemässen Vorrichtung werden die bei der Schwenkbewegung auftretenden Beschleunigungs-Momente durch die spezielle Anordnung der Massenschwerpunkte weitgehend eliminiert und dadurch eine exakte, sogenannte Bahntreue der einzelnen Elemente gewährleistet.

Weitere, auf die erfindungsgemässe Vorrichtung bezogene Merkmale ergeben sich aus der Beschreibung, der Zeichnung sowie der entsprechenden Patentansprüche.

Eine weitere Aufgabe der Erfindung wird darin gesehen, ein zur integrierenden Aufnahme der erfindungsgemässen Vorrichtung ausgebildetes Trägerelement anzugeben, welches eine in sich stabile Bauweise mit relativ geringem Eigengewicht aufweist und zusammen mit der Vorrichtung eine Baueinheit bildet, wobei die Baueinheit für die erforderlichen Bewegungen in der Ebene frei verstellbar einer zur Herstellung der Drahtverbindung an den elektronischen Komponenten ausgebildeten Arbeitsstation zuführbar ist.

Diese Aufgabe wird erfindungsgemäss dadurch gelöst, dass das Trägerelement als einstückige, durch eine obere Deckenwandung, einen unteren Boden sowie diese miteinander verbindende Wände gebildete starre, gehäuseartige Zellenkonstruktion in Form eines quaderfömigen Hohlkörpers mit Kammern zur Aufnahme und schwenkbaren Lagerung des aus den einzelnen Elementen gebildeten Kontaktier-Vorrichtung und des damit wirkverbunde nen elektromotorischen Antriebs sowie eines Drehgebers ausgebildet ist, und dass die Unterseite des Trägerelements als ein vakuumvorspannbares Luftkissenlager ausgebildet ist, welches eine vollumfänglich von einer Druckzone umgebene Vakuumzone aufweist.

Weitere, auf das Trägerelement bezogene Merkmale ergeben sich aus der Beschreibung und der Zeichnung.

Die Erfindung wird nachstehend anhand der Zeichnung beschrieben. Es zeigt:
- Fig. 1: eine in Schnittansicht dargestellte und mit einem Kontaktierorgan versehene Vorrichtung zur ultraschallkontaktierenden Drahtverbindung,
- Fig. 2: die Vorrichtung gemäss Fig.1 in Draufsicht,
- Fig. 3: eine erste Variante eines perspektivisch dargestellten Tragrahmens für das Kontaktierorgan gemäss Fig.1,
- Fig. 4: den Tragrahmen gemäss Fig.3 in Draufsicht,
- Fig. 5: ein in Schnittansicht dargestelltes Teilstück des Tragrahmens gemäss der Linie V-V in Fig.4,
- Fig. 6: ein in Ansicht dargestelltes Teilstück des Tragrahmens gemäss Pfeilrichtung B in Fig.4,
- Fig. 7: eine Justiervorrichtung für einen im ersten Tragrahmen angeordneten zweiten Tragrahmen des Kontaktierorgans gemäss Fig.1 und 2,
- Fig. 8: eine Klemmvorrichtung für das Kontaktierorgan gemäss Fig.1 und 2,
- Fig. 9: den in Ansicht dargestellten zweiten Tragrahmen,
- Fig. 10: den in Seitenansicht dargestellten zweiten Tragrahmen gemäss Fig.9,
- Fig. 11: einen in Schnittansicht dargestellten elektromotorischen Antrieb für das Kontaktierorgan gemäss Fig.1 und 2,
- Fig. 12: einen in Fig.1 durch einen mit A bezeichneten Kreis dargestellten Ausschnitt einer mit den beiden Tragrahmen in Wirkverbindung stehende Kontaktvorrichtung,
- Fig. 13: eine schematische Darstellung des in Fig.1 dargestellten Kontaktierorgans,
- Fig. 14: eine zweite Variante des als perspektivische Sprengzeichnung dargestellten Kontaktierorgans,
- Fig. 14a: einen als Blockschaltbild dargestellten elektrischen Stromkreis für die Kontaktvorrichtung gemäss Fig.14
- Fig. 15: ein im Schnitt dargestelltes Trägerelement für das Kontaktierorgan der Vorrichtung gemäss Fig.1,
- Fig. 16: das in Draufsicht und im Schnitt dargestellte Trägerelement gemäss Fig.15,
- Fig. 17: das als Einzelheit und in perspektivischer Ansicht dargestellte Trägerelement, und
- Fig. 18: den in Ansicht dargestellten Boden des Trägerelements gemäss Fig.15.

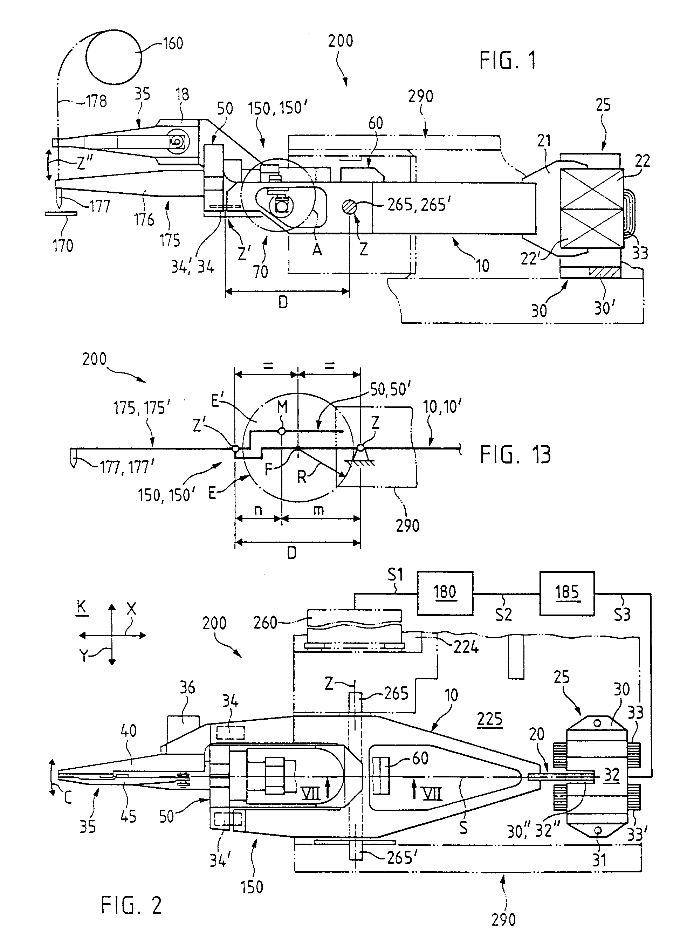

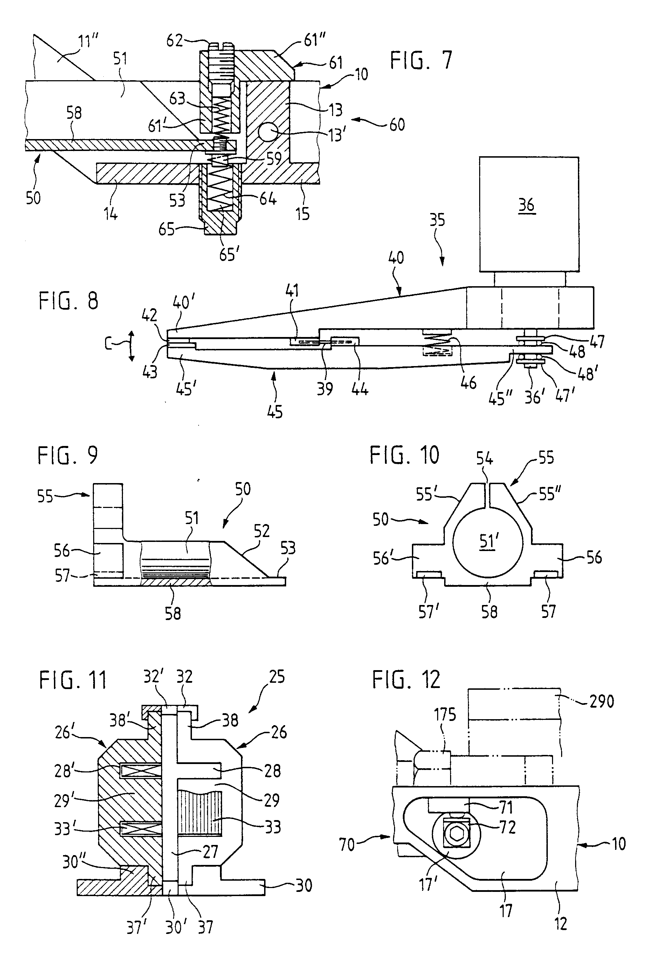

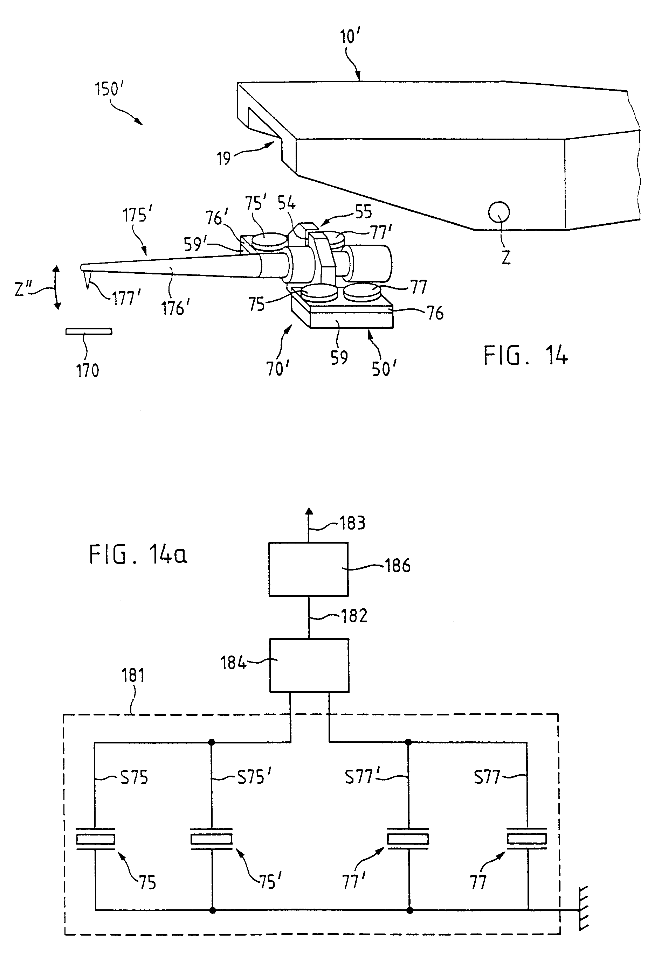

Zur Verdeutlichung der Erfindung und als allgemeine System-Übersicht ist in Fig.1 in Schnittansicht und in Fig.2 in Draufsicht eine in der Gesamtheit mit 200 bezeichnete Vorrichtung der Halbleiter-Verbindungstechnik dargestellt, welche nachstehend im einzelnen beschrieben wird:
Die Vorrichtung 200 umfasst im wesentlichen ein in Fig.1 und Fig.2 durch strichpunktierte Linien im Umriss dargestelltes Trägerelement 290, welches als starre, gehäuseartige Zellenkonstruktion mit mindestens zwei nutzbaren inneren Kammern 225,224 (Fig.2) ausgebildet ist. Das Trägerelement 290 dient zur Aufnahme eines in der Gesamtheit mit 150 oder 150′ bezeichneten Kontaktierorgans, eines mit dem Kontaktierorgan 150 oder 150′ in Wirkverbindung stehenden und in der Kammer 224 des Trägerelements 290 gelagerten inkrementalen Drehgebers 260 (Encoder) oder dergleichen sowie eines mit dem Kontaktierorgan 150 oder 150′ wirkverbundenen, elektromotorischen Antriebs 25.
Das an dem einen Ende mit dem elektromotorischen Antrieb 25 wirkverbundene Kontaktierorgan 150 oder 150′ umfasst im wesentlichen einen ersten Tragrahmen 10, einen zur Aufnahme eines an sich bekannten Energietransducers 175,175′ ausgebildeten zweiten Tragrahmen 50,50′ sowie eine entsprechend ausgebildete Klemmvorrichtung 35. Das mit dem Antrieb 25 wirkverbundene Kontaktierorgan 150,150′ ist mit den einzelnen Teilen um eine gemeinsame, etwa horizontal angeordnete Achse Z zweier Achszapfen 265,265′ um einige Winkelgrade in Pfeilrichtung Z˝ (Fig.1) etwa oszillierend (schwingend) in dem Trägerelement 290 gelagert.
In Abhängigkeit von der Schwenkbewegung in Pfeilrichtung Z˝ werden, wie in Fig.2 schematisch dargestellt, von dem Drehgeber 260 bewegungsabhängige Signale S1 einer ersten Auswerteeinheit 180 zugeführt. Die in der ersten Auswerteeinheit 180 entsprechend ausgewerteten und verarbeiteten Signale S1 werden als Signale S2 einer ersten Regeleinheit 185 und anschliessend als Steuer- oder Regelsignale S3 dem elektromotorischen Antrieb 25 zugeführt.
Die aus den wesentlichen Teilen 290 und 260 und dem die einzelnen Teile umfassenden Kontaktierorgan 150 oder 150′ bestehende Vorrichtung 200 bildet eine in sich geschlossene Funktionseinheit, welche zur hochdynamischen und exakten Zustellbewegung des am Kontaktierorgan 150,150′ (Fig.1,13) angeordneten und mit einem Horn 176 und einer Kapillare 177 versehenen Transducer 175,175′ zu einer Arbeitsstation, dass heisst, zu einem mit 170 bezeichneten, schematisch dargestellten Chip (elektronisches Komponententeil) ausgebildet ist.
Weiterhin erkennt man in Fig.1 eine schematisch dargestellte Drahtspule 160 einer hier nicht näher dargestellten Bonddraht-Abwickelvorrichtung, von welcher ein mit 178 bezeichneter Bonddraht der am Kontaktierorgan 150 oder 150′ angeordneten Klemmvorrichtung 35 zugeführt und von dort zentrisch in die Kapillare 177 geführt wird. Die erforderliche Druck- oder Anpresskraft der Kapillare 177 wird im wesentlichen durch die Wirkung, beziehungsweise durch die Schwingungen des elektromotorischen Antriebs 25 erreicht.
In einer ersten Phase sind hierbei entsprechende Kontakte 71,72 einer mit dem ersten Tragrahmen 10 sowie mit dem zweiten, zur Aufnahme des Transducers 175 ausgebildeten Tragrahmen 50 wirkverbundenen Kontaktvorrichtung 70 (Fig.12) geschlossen. Bei entsprechend am Chip 170 wirkender Kraft werden in einer zweiten Phase die Kontakte 71,72 geöffnet und entsprechende Signale dem Transducers 175 zugeführt, von welchem eine in an sich bekannter Weise am Drahtende angeschmolzene Drahtkugel (nicht dargestellt) mittels der Kapillare 177 auf den Chip 170 gedrückt wird.
Die Vorrichtung 200 ist mittels nicht näher dargestellter und im wesentlichen mit dem Trägerelement 290 wirkverbundener Antriebe auf einer entsprechend ausgebildeten, nicht näher dargestellten Gleitplatte gemäss dem in Fig.2 dargestellten Koordinatensystem K längs zweier, in der Ebene rechtwinklig zueinander orientierter Koordinaten etwa in Pfeilrichtung X und Y freischwebend verstellbar. Zur Erreichung der freischwebenden Bewegung der gesamten Vorrichtung 200 auf einer entsprechend ausgebildeten Grundplatte (nicht dargestellt) ist der Boden des Trägerelements 200 mit einem entsprechend ausgebildeten Luftkissenlager versehen.

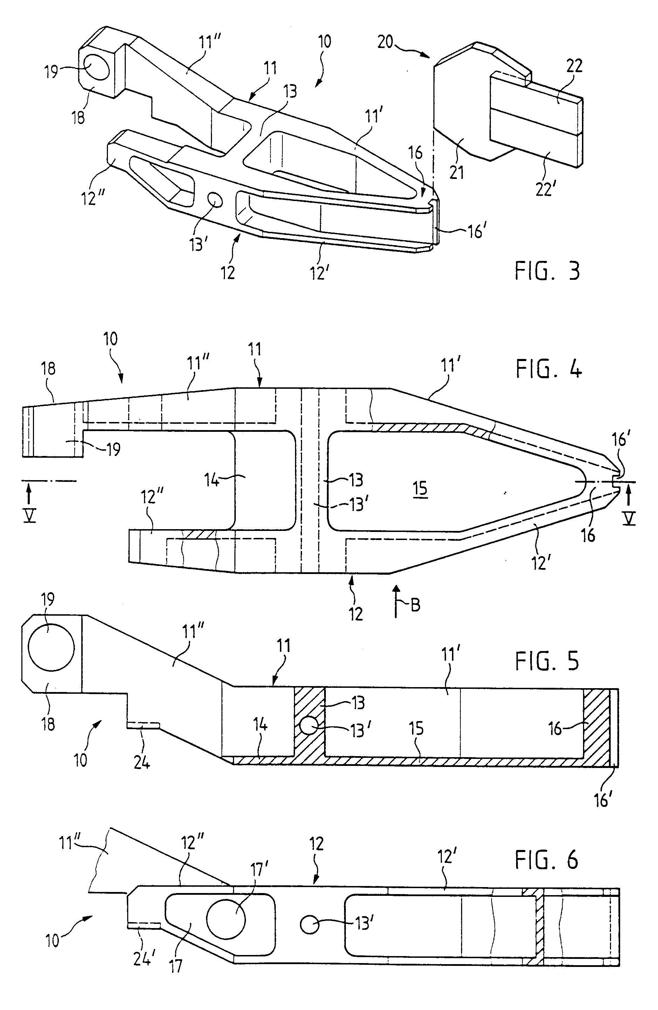

In Fig.3 ist eine Variante des ersten Tragrahmens 10 in perspektivischer Ansicht und in Fig.4 in grösserem Massstab in Draufsicht dargestellt und man erkennt zwei Tragarme 11 und 12, welche zwei etwa in parallelem Abstand zueinander angeordnete und im mittleren Bereich durch einen Steg 13 miteinander verbundene vordere, erste Teilstücke 11˝ und 12˝ sowie zwei im hinteren Bereich 16 miteinander vereinigte, zweite Teilstücke 11′ und 12′ aufweist. Zwischen den beiden hinteren, schräg zueinander verlaufenden Teilstücke 11′ und 12′ ist ein vom hinteren Bereich 16 bis zum Steg 13 reichender Boden 15 und zwischen den beiden vorderen Teilstücken 11˝ und 12˝ ein Bodenteilstück 14 vorgesehen. In der nicht näher bezeichneten senkrechten Wandung des hinteren Bereichs 16 ist eine senkrechte, nutartig ausgebildete Ausnehmung 16′ vorgesehen, welche zur Aufnahme eines in Fig.3 im Abstand dazu angeordneten Magnetkörpers 20 ausgebildet ist. Der etwa schwertartig ausgebildete und mit dem elektromotorischen Antrieb 25 (Fig.1) in Wirkverbindung stehende Magnetkörper 20 besteht aus einer Befestigungsplatte 21 und zwei daran angeordneten Magnetplatten 22,22′ und ist mit nicht dargestellten Mitteln, beispielsweise durch Kleben oder dergleichen mit dem ersten Tragrahmen 10 verbunden.
Die Tragarme 11 und 12 mit ihren Teilstücken 11′,11˝ und 12′,12˝ haben, wie in Fig.6 im Teilschnitt dargestellt, einen etwa [-förmigen Profilquerschnitt. Der die beiden Tragarme 11 und 12 miteinander verbindende Steg 13 wird von einer etwa quer zu den Tragarmen 11,12 orientierten Bohrung 13′ durchdrungen. Das vordere Teilstück 11˝ des Tragarms 11 ist, wie in Fig.5 dargestellt, in bezug zu dem Teilstück 11′ nach oben abgewinkelt ausgebildet und an seinem vorderen Ende mit einem Lagerteil 18 versehen. Das Lagerteil 18 wird von einer Bohrung 19 durchdrungen und ist, wie in Fig.1,2 dargestellt, zur Aufnahme und Befestigung der Klemmvorrichtung 35 vorgesehen.
Fig.5 zeigt den ersten Tragrahmen 10 im Schnitt gemäss der Linie V-V in Fig.4 und man erkennt den Tragarm 11 mit dem etwa horizontalen Teilstück 11′, das in bezug dazu nach oben abgewinkelte Teilstück 11˝ mit dem von der Bohrung 19 durchdrungenen Lagerteil 18, den Steg 13 mit der Bohrung 13′, den Boden 15 mit dem stegartig daran angeformten Bereich 16 sowie das Bodenteilstück 14. An der Unterseite des vorderen Teilstücks 11˝ ist eine Ausnehmung 24 vorgesehen, welche zur Aufnahme und Befestigung eines ersten Federelements 34 (Fig.1,2) ausgebildet ist.
In Fig.6 ist der erste Tragrahmen 10 in Ansicht gemäss Pfeilrichtung B in Fig.4 dargestellt und man erkennt den aus den Teilstücken 12′,12˝ gebildeten, horizontalen Tragarm 12 sowie ein Teil des abgewinkelten Teilstücks 11˝ des Tragarms 11. Das vordere Teilstück 12˝ ist mit einer Ausnehmung 24′ versehen, welche zur Aufnahme und Befestigung eines zweiten Federelements 34′ (Fig.1,2) ausgebildet ist. Am vorderen Teilstück 12˝ des Tragarms 12 ist eine Tasche 17 mit Öffnung 17′ vorgesehen, in welcher Tasche 17 die mit dem ersten und zweiten Tragrahmen 10,50 wirkverbundene und in Verbindung mit Fig.12 näher beschriebene Kontaktvorrichtung 70 angeordnet ist.

In Fig.8 ist die Klemmvorrichtung 35 in Draufsicht dargestellt und man erkennt ein erstes Klemmstück 40 sowie ein zweites Klemmstück 45, welche Klemmstücke 40,45 an dem einen Ende im wesentlichen mittels eines Achszapfens 36′ eines Elektromagneten 36 und etwa im mittleren Bereich durch ein als Blattfeder 39 ausgebildetes Verbindungselement miteinander wirkverbunden sind. Das hintere Ende 45˝ des Klemmstücks 45 ist zwischen zwei elastischen Elementen 48,48′ (O-Ringe ) angeordnet, welche durch Scheiben 47,47′ am Achszapfen 36′ des Elektromagneten 36 gehalten sind. Die Blattfeder 39 ist mit einem entsprechend ausgebildeten Halteteil 41 an dem ersten Klemmstück 40 und mit einem zweiten Halteteil 44 an dem zweiten Klemmstück 45 mit nicht dargestellten Befestigungsmitteln (Schraubverbindung) lösbar befestigt. Die Blattfeder 39 bildet im wesentlichen eine nicht näher bezeichnete Gelenkstelle der beiden von dem Elektromagneten 36 gegen die Rückstellkraft einer zwischen den beiden Klemmstücken 40,45 angeordneten Druckfeder 46 in Pfeilrichtung C relativ zueinander bewegbaren Klemmstücke 40 und 45. Am vorderen Ende 40′ des Klemmstücks 40 und sowie am vorderen Ende 45′ des Klemmstücks 45 ist je ein Klemmplättchen 42,43 mit jeweils absolut ebener, korrespondierend zueinander angeordneter Anlagefläche (nicht näher bezeichnet) vorgesehen, zwischen welchen Anlageflächen der relativ dünne, im µ-Bereich liegende Bonddraht 178 (Fig.1) geklemmt und wieder freigegeben wird.

Fig.9 und 10 zeigt den zweiten, entsprechend zur Aufnahme des Transducers 175 ausgebildeten Tragrahmen 50 in teilweise aufgebrochen dargestellter Ansicht sowie in Seitenansicht. Der einen Boden 58 aufweisende Tragrahmen 50 hat einen etwa halbschalenartig ausgebildeten Körper 51, welcher im vorderen Bereich ein stegartig ausgebildetes und von einer Bohrung 51′ durchdrungenes Klemmteil 55 mit zwei durch einen Schlitz 54 (Fig.10) getrennte Teile 55′,55˝ aufweist und im hinteren Bereich mit einer Abschrägung 52 und einem Vorsprung 53 versehen ist.
Im vorderen Bereich sind die zur Halterung des Transducers 175 mit nicht dargestellten Schrauben oder dergleichen zusammenpressbaren Klemmteile 55′,55˝ je mit einem seitlichen Auflageteil 56,56′ versehen, in welchen jeweils eine taschenartige Ausnehmung 57,57′ zur Aufnahme und Befestigung der Federelemente 34,34′ (hier nicht dargestellt) ausgebildet ist. Das einzelne Federelement 34,34′ ist, wie in Fig.1 und 2 schematisch dargestellt, einerseits mit dem ersten Tragrahmen 10 und andererseits mit dem zweiten Tragrahmen 50 wirkverbunden und bildet im wesentlichen eine im Abstand D zu der Achse Z angeordnete Gelenkstelle Z′, mittels welcher der zweite Tragrahmen 50 zusammen mit dem Transducer 175 (Ultraschalltransducer) relativ zu dem ersten Tragrahmen 10 in Pfeilrichtung Z˝ zur Freigabe der Kontakte 71,72 (Kontakte stehen nicht mehr miteinander in Wirkverbindung) beweglich ist. Die Achse Z und Gelenkstelle Z′ bilden jeweils eine auch als sogenannte Schwenkachse zu bezeichnende Wirk-Verbindungsstelle der beiden Tragrahmen 10 und 50.

Fig.11 zeigt den elektromotorischen Antrieb 25, bei welchem die eine Hälfte in Ansicht und die andere Hälfte in Schnittansicht dargestellt ist. Der Antrieb 25 umfasst im wesentlichen eine als Trägerglied ausgebildete Grundplatte 30, zwei durch einen Spalt 27 im Abstand zueinander angeordnete Statorkörper 26,26′, zwei Spulenkörper 33,33′ sowie ein Halteteil 32. Die beiden im Profilquerschnitt etwa E-förmig ausgebildeten Statorkörper 26,26′ haben durch einen mittleren Steg 29,29′ voneinander getrennte Ausnehmungen 28,28′, in welchen die Spulenkörper 33,33′ angeordnet sind. Die Statorkörper 26,26′ haben untere Stege 37,37′ und obere Stege 38, 38′. Die unteren Stege 37,37′ sind in der mit entsprechenden Ausnehmungen (nicht näher bezeichnet) versehenen Grundplatte 30 durch einen Steg 30′ im Abstand zueinander angeordnet. Die oberen Stege 38,38′ sind in dem ebenfalls mit Ausnehmungen (nicht näher bezeichnet) versehenen Halteteil 32 durch einen Steg 32′ im Abstand zueinander angeordnet. Die Grundplatte 30 sowie das obere Halteteil 32 sind, wie in Fig.2 schematisch dargestellt, jeweils mit einem bis zum Steg 30′ reichenden Schlitz 30˝, beziehungsweise mit einem bis zum Steg 32′ reichenden Schlitz 32˝ für die Bewegung des schwertartig ausgebildeten Magnetkörpers 20 mit den Magnetplatten 22,22′ versehen. Der Antrieb 25 ist mittels Schrauben 31 (Fig.2) am Boden der Kammer 225 des Trägerelements 290 lösbar befestigt.
Durch eine entsprechende Erregung, vorzugsweise durch eine gesteuerte oder geregelte Gleichstrom-Erregung der Spulenkörper 33,33′ wird eine vertikale Relativbewegung des am ersten Tragrahmen 10 angeordneten Magnetkörpers 20 zu den Statorkörpern 26,26′ beziehungsweise zu dem am Trägerelement 290 befestigten Antriebs 25 erreicht.

In Fig.7 ist eine in der Gesamtheit mit 60 bezeichnete Vorrichtung zur Einstellung und Justierung der Relativbewegung des zweiten Tragrahmens 50 in bezug zu dem ersten, um die beiden Achszapfen 23,23′ um einige Winkelgrade schwenkbaren ersten Tragrahmens 10 dargestellt. Die Vorrichtung 60 umfasst ein Winkelstück 61, welches mit einem Schenkelteil 61˝ am Steg 13 des Tragrahmens 10 mit nicht dargestellten Mitteln befestigt ist und in einem senkrechten Stegteil 61′ eine nicht bezeichnete Bohrung aufweist, welche Bohrung zur Aufnahme einer durch eine Stellschraube 62 von der einen Seite gegen den Vorsprung 53 des Tragrahmen-Bodens 58 pressbare Druckfeder 63 vorgesehen und ausgebildet ist. Eine im Boden 14 des ersten Tragrahmens 10 angeordnete und mit einem Gewinde verstellbare Stellschraube 65 hat eine Sacklochbohrung 65′ zur Aufnahme einer gegen die andere Seite des Vorsprungs 53 wirkenden Druckfeder 64. Die zweite Druckfeder 64 ist vorzugsweise mit einem am Vorsprung 53 angeordneten Zapfen 59 in der Wirklage gehalten. Die erste Stellschraube 62 sowie die zweite Stellschraube 65 sind nach der eigentlichen Justierung mit nicht dargestellten Mitteln zur Sicherung ihrer Lage entsprechend fixierbar. Mittels der vorstehend beschriebenen und als Federspannsystem ausgebildeten Vorrichtung 60 ist im wesentlichen die erforderliche Aufprall- beziehungsweise die Anpresskraft der Kapillare 176 am Chip 170 exakt, den Anforderungen entsprechend einstellbar.

Fig.12 zeigt die in Verbindung mit der Arbeits- und Funktionsweise eingangs beschriebene und in der Gesamtheit mit 70 bezeichnete Kontaktvorrichtung und man erkennt ein Teilstück des Trägerelements 290, ein Teilstück des Transducers 175 sowie den mit der Ausnehmung 17 und Öffnung 17′ versehenen Tragarm 12 des ersten Tragrahmens 10. In der Ausnehmung 17 ist mit nicht näher dargestellten Mitteln ein erstes, schematisch dargestelltes Kontaktorgan 71 und an dem hier nicht näher dargestellten zweiten Tragrahmen 50 das die Öffnung 17′ durchdringende zweite Kontaktorgan 72 angeordnet.

Der mit dem Transducer 175 eine Baueinheit bildende zweite Tragrahmen 50 ist, wie in Fig.13 schematisch und symbolisch dargestellt, mit der Gelenkstelle Z′ im Abstand D zu der Achse Z angeordnet. Die Achse Z des Tragrahmens 10 wird hierbei im wesentlichen durch die im ersten Tragrahmen 10 angeordneten und im Trägerelement 290 gelagerten Achszapfen 265,265′ und die Gelenkstelle Z′ durch die am ersten und zweiten Tragrahmen 10 und 50 angeordneten Federelemente 34,34′ gebildet. Die beiden Tragrahmen 10 und 50 sind durch die Federelemente 34,34′ derart miteinander wirkverbunden, dass der zweite Tragrahmen 50 ausschliesslich in einer bestimmten Arbeitsphase (Anpressung der Kapillare 176 am Chip 170) des Kontaktierorgans 150 relativ zu dem ersten Tragrahmen 10 in Pfeilrichtung Z˝ beweglich ist.

Die Ausbildung des zweiten Tragrahmens 50 sowie die Anordnung des Transducers 175 in dem Tragrahmen 50 ist so gewählt, dass ein in Fig.13 fiktiv angenommener und dargestellter, auf der Symmetrieachse S (Fig.2) liegender und rechnerisch zu bestimmender Massenschwerpunkt M der Teile 175 und 50 innerhalb eines etwa eine Bewegungsebene definierenden Kreises E liegt, vorzugsweise aber im oberen Halbkreis E′ des mit E bezeichneten Kreises liegt. Der Kreis E ist mit seinem Zentrum F in der Mitte einer zwischen der Achse Z und der Gelenkstelle Z′ gebildeten, nicht näher bezeichneten Geraden angeordnet, wobei der Radius R des Kreises E < als die Hälfte des Abstandes D gewählt ist.
Die vorstehend beschriebene und bevorzugte Anordnung des Massenschwerpunktes M im Bereich der oberen Halbkreisebene E′ gewährleistet eine optimale Auswuchtung und Massenverteilung der einzelnen Elemente, so dass während der gemeinsamen Schwenkbewegung (erste Bewegungsphase) der entsprechenden Teile 10,50,175 in Pfeilrichtung Z˝ (Fig.1) eine ausreichende Lagenstabilität gewährleistet ist, dass heisst, dass eine Relativbewegung des Transducers 175 mit dem Tragrahmen 50 in bezug zu dem ersten Tragrahmen 10 bei der ersten Schwenkbewegung weitgehend ausgeschlossen ist.

Fig.14 zeigt in perspektivisch dargestellter Sprengzeichnung eine Variante eines in der Gesamtheit mit 150′ bezeichneten Kontaktierorgans und man erkennt ein Teilstück eines Tragrahmens 10′ sowie eine in der Gesamtheit mit 70′ bezeichnete Kontaktvorrichtung. Der mit entsprechenden Bohrungen für die Achse Z versehene Tragrahmen 10′ hat einen etwa ∩-förmigen Profilquerschnitt und ist an dem einen, hinteren Ende analog dem Tragrahmen 10 (Fig.1,2) ausgebildet und mit dem Magnetkörper 20 versehen, welcher mit dem, in Fig.14 nicht näher dargestellten, elektromotorischen Antrieb 25 wirkverbunden ist. An dem anderen, vorderen Ende ist der Tragrahmen 10′ mit einer entsprechend ausgebildeten Ausnehmung 19 für die Kontaktvorrichtung 70′ sowie mit nicht näher dargestellten und bezeichneten Montageflächen zur Befestigung der Kontaktvorrichtung 70′ ausgebildet. Die Kontaktvorrichtung 70′ hat einen zur Lagerung des Transducers 175′ ausgebildeten Tragrahmen 50′ mit zwei im Abstand zueinander angeordneten und durch ein Klemmteil 55 miteinander verbundene Auflageteile 59,59′. Der Tragrahmen 50′ ist im wesentlichen wie der in Fig.9 und Fig.10 dargestellte Tragrahmen 50 ausgebildet und umfasst das aus den Teilen 55′,55˝ und dem Spalt 54 gebildete und zur Aufnahme und Halterung des Transducers 175′ vorgesehene Klemmteil 55.
Abweichend von dem Tragrahmen 50 gemäss Fig.9 und 10 ist an den beiden Auflageteilen 59,59′ des Tragrahmens 50′ je eine Leiterplatte 76,76′ oder dergleichen angeordnet und mit nicht dargestellten Mitteln befestigt.
In dem in Fig.14 dargestellten Ausführungsbeispiel sind auf jeder Leiterplatte 76,76′ zwei im Abstand zueinander angeordnete Piezo-Elemente 75,77 beziehungsweise 75′,77′ vorgesehen, welche mit nicht dargestellten Mitteln mit der entsprechenden Leiterplatte 76 oder 76′ elektrisch wirkverbunden sind. In montiertem, nicht näher dargestellten Zustand, bei welchem der zweite Tragrahmen 50′ beispielsweise durch eine Schraubverbindung (nicht dargestellt) am ersten Tragrahmen 10′ befestigt ist, stehen die vier Piezo-Elemente 75,75′ und 77,77′ mit entsprechender Vorspannung mit dem ersten Tragrahmen 10′ in Wirkverbindung.
Die vorstehend in Verbindung mit Fig.13 beschriebene, spezielle Anordnung des Massenschwerpunktes M innerhalb des Kreises E ist bei dieser Variante im wesentlichen analog ausgebildet. Das etwa mit gleichem Abstand zwischen den korrespondierend zueinander angeordneten Piezo-Elementen 75,77 beziehungsweise 75′,77′ angeordnete Klemmteil 55 des Tragrahmens 50′ bildet hierbei die fiktive Gelenkstelle Z′ (Fig.13) für die Relativbewegung des zweiten Tragrahmens 50′ in bezug zu dem ersten Tragrahmen 10′.
Bei diesem, bevorzugten Ausführungsbeispiel wird bei der Schwenkbewegung Z˝ des Kontaktierorgans 150′ beim Auftreffen (touch down) der Kapillare 177′ auf den Chip 170 eine entsprechende Kraft erzeugt. Die Kraft bewirkt aufgrund der geometrischen Anordnung, dass die beiden vorderen Piezo-Elemente 75,75′ zusätzlich zu der Vorspannung entsprechend belastet und die beiden hinteren Piezo-Elemente 77,77′, aufgrund der im µ-Bereich liegenden Beweglichkeit der Teile 175′,50′ um die fiktive Gelenkstelle Z′, entlastet werden.
Auch bei diesem Ausführungsbeispiel gemäss Fig.14 werden, wie bei dem in Fig.2 dargestellten Ausführungsbeispiel, in der ersten Auswerteeinheit 180 entsprechende Signale S1 verarbeitet und als Signale S2 der ersten Regeleinheit 185 sowie als Steuer- oder Regelsignale S3 dem elektromotorischen Antrieb 25 zugeführt. Zusätzlich dazu werden in Abhängigkeit von der bei der Kapillarberührung (touch down) entstehenden Be- und Entlastung der Piezo-Elemente 75,75′ und 77,77′, wie in dem Blockschaltbild gemäss Fig.14a dargestellt, entsprechende kraftabhängige Signale S75,S75′ und S77,S77′ über eine Schaltung 181 einer zweiten Auswerteeinheit 184 zugeführt, in welcher Auswerteeinheit 184 beispielsweise eine Impedanzwandlung, Verstärkung und/oder Differenzbildung der Signale S75, S75′ und S77,S77′ erfolgt. Die so ermittelten Werte werden vorzugsweise in Form einer elektrischen Spannung über einen Ausgang 182 einer zweiten Regeleinheit 186 zur Bildung entsprechender Steuer- oder Regelsignale zugeführt, welche über einen Ausgang 183 dem elektromotorischen Antrieb 25 zugeführt werden.
Die während des Bondvorgangs auf diese Weise vorzugsweise fortlaufend ermittelten Signale S75,S75′ und S77,S77′ können zur Detektion der Kapillarberührung sowie zur Beurteilung des jeweiligen Kraftverlaufs verarbeitet und zur Steuerung oder Regelung des elektromotorischen Antriebs 25 und somit zur Regelung der Bondkraft verwendet werden.

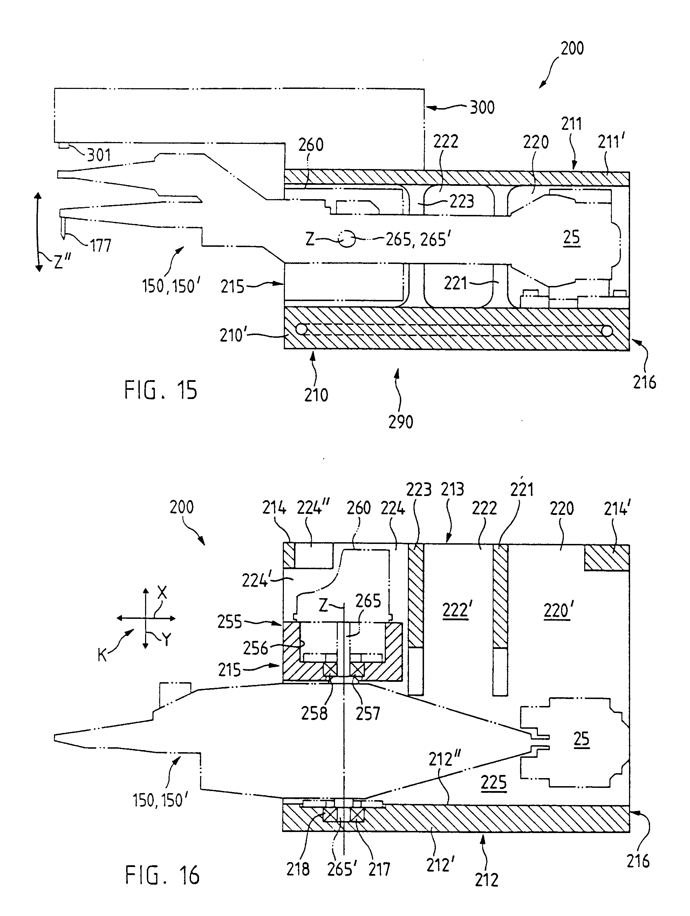

In Fig.15 ist in Schnittansicht und in Fig.16 in Schnittdraufsicht die in ihrer Gesamtheit mit 200 bezeichnete Vorrichtung der Halbleiter-Verbindungstechnik dargestellt, welche im wesentlichen das in dieser Darstellung schematisch und durch strichpunktierte Linien im Umriss dargestellte Kontaktierorgan 150 oder 150′ (Bonder), einen trägerartig ausgebildeten Ausleger 300 (nur in Fig.15 dargestellt) mit daran angeordnetem optischen Abtastelement 301 (Sensor) sowie das entsprechend für die Teile 150 oder 150′ und 300 ausgebildete Trägerelement 290 umfasst. Das am vorderen Ende mit der schematisch dargestellten Kapillare 177 versehene, wippenartig ausgebildete Kontaktierorgan 150 oder 150′ ist, wie in Fig.16 dargestellt, in das etwa gehäuseartig ausgebildete Trägerelement 290 einsetzbar und an dem einen Ende mit dem elektromotorischen Antrieb 25 wirkverbunden. Das Kontaktierorgan 150 oder 150′ ist etwa im mittleren Bereich mittels im Abstand zum Antrieb 25 angeordneter Achszapfen 265 in entsprechend ausgebildetem Lagerstück 255 und mittels einem zweiten, korrespondierend zum ersten Achszapfen 265 angeordneten Achszapfen 265′ in einer mit 212′ bezeichneten Wand des Trägerelements 290 gelagert (Fig.2). Das mit abgesetzt ausgebildeten Ausnehmungen 256 und 257 versehene Lagerstück 255 wird von dem Achszapfen 265 durchdrungen. Der Achszapfen 265 ist mit dem schematisch und mittels strichpunktierter Linien dargestellten inkrementalen Drehgeber 260 (Encoder) wirkverbunden. Das Kontaktierorgan 150 oder 150′ ist mit dem einen Achszapfen 265 in einem in der Ausnehmung 257 angeordneten Lagerteil 258 (Kugellager) und mit dem anderen Achszapfen 265′ in einem Lagerteil 218 um die gemeinsame Achse Z in Pfeilrichtung Z˝ (Fig.1) um einige Winkelgrade schwenkbar gelagert.

In Fig.16 ist das Trägerelement 290 für die Vorrichtung 200 im Schnitt und in Draufsicht dagestellt und man erkennt das zur Aufnahme und Lagerung des Messelements 260 sowie zur Lagerung des Kontaktierorgans 150 oder 150′ als einbaubares Einzelteil ausgebildete Lagerstück 255, welches in das Trägerelement 290 eingebaut sowie mit nicht näher dargestellten Mitteln, beispielsweise durch eine Schraubverbindung auswechselbar befestigt ist. An dieser Stelle sei darauf hingewiesen, dass das gehäuseartige Trägerelement 290 in nicht dargestellter Weise in diesem Bereich mit einem mit dem Trägerelement 290 eine Einheit bildenden Lagerstück 255 zur Aufnahme und Lagerung der Teile 260,265 und 150 oder 150′ versehen sein kann.

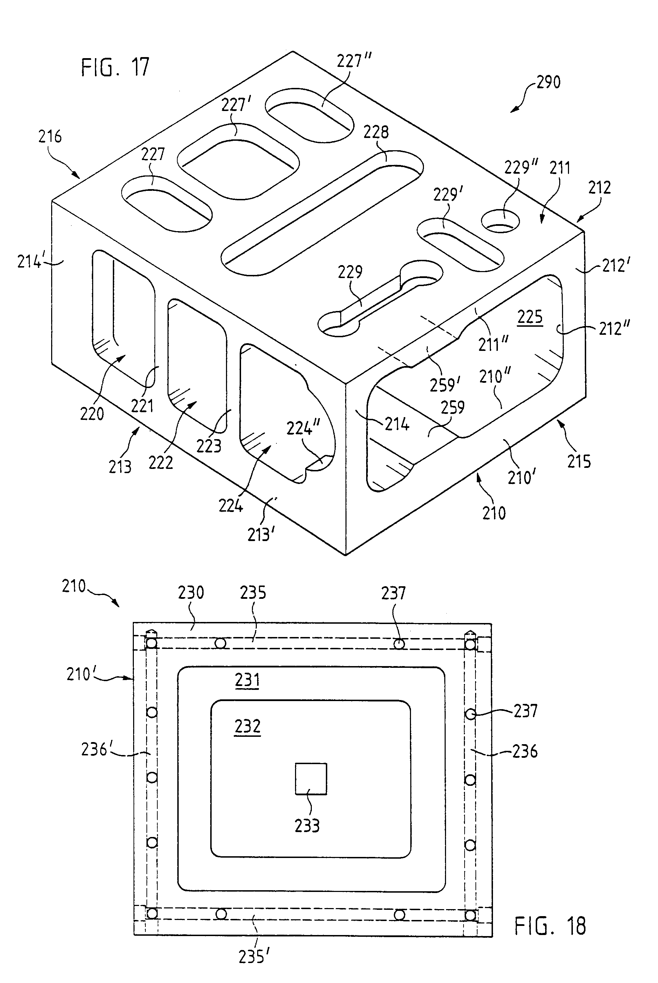

Das in Fig.17 in perspektivischer Ansicht dargestellte Trägerelement 290 ist etwa als quaderförmiger, einstückiger Hohlkörper mit nutzbaren Hohlräumen zur Aufnahme der wesentlichen Funktionsteile 150 oder 150′,25 und 260 ausgebildet und hat eine Unterseite 210, eine Oberseite 211 zur Aufnahme des Auslegers 300, Seiten 212 und 213, eine Stirnseite 215 sowie eine Rückseite 216 und wird nachstehend im einzelnen beschrieben:
Das gehäuseartige Trägerelement 290 ist als starre Zellenkonstruktion ausgebildet und hat an seiner mit 210 bezeichneten Unterseite einen als horizontale Platte ausgebildeten Boden 210′ und in parallelem Abstand dazu an seiner Oberseite 211 eine Deckenwandung 211′. An der einen mit 212 bezeichneten Seite ist eine erste, vertikale Wand 212′ und an der anderen, gegenüberliegenden und mit 213 bezeichneten Seite ist eine zweite, vertikale Wand 213′ vorgesehen. Die beiden, den Boden 210′ mit der Deckenwandung 211′ verbindenden Wände 212′und 213′ sind in parallelem Abstand zueinander angeordnet.
Zur zentrierenden Lagerung und Befestigung des einsetzbaren Lagerstücks 255 ist im vorderen Bereich des Trägerelements 290 an der Innenseite 210˝ des Bodens 210′ sowie an der Innenseite 211˝ der Deckenwandung 211′ jeweils eine entsprechend ausgebildete und in Fig.17 teilweise dargestellte Anlage- oder Zentrierfläche 259,259′ vorgesehen.
Die zweite, vertikale Wand 213′ hat im Abstand zueinander angeordnete Ausnehmungen 220,222 und 224, wobei zwischen den Ausnehmungen 220 und 222 sowie 222 und 224 je eine Rippe 221,223 vorgesehen ist. Durch die vom Boden 210′ bis zur Deckenwandung 211′ reichenden und etwa nach innen, in Richtung der ersten Wand 212′ orientierten Rippen 221 und 223 sowie durch die beiden Eckstücke 214,214′ der Wand 213′ werden im Inneren des Trägerelements 290, wie in Fig.16 dargestellt, entsprechende Hohlräume oder Kammern 220′,222′ und 224′ gebildet. Das vordere Eckstück 214 ist zur Auflage des Messelements 260 mit einer entsprechend ausgebildeten Ausnehmung 224˝ versehen. Zusätzlich zu den Kammern 220′,222′ und 224′ ist die Hauptkammer 225 vorgesehen. Die Kammer 224′ dient hierbei zur Aufnahme des Messelements 260 und die Hauptkammer 225 zur Aufnahme des in Fig.17 nicht dargestellten Kontaktierorgans 150 oder l50'sowie des Antriebs 25.
Die Wand 213′ sowie die nicht näher bezeichnete Wand der Rückseite 216 sind jeweils mit nicht dargestellten, im Abstand zueinander angeordneten Gewindebohrungen zur Befestigung des Trägerteils 290 an einen nicht dargestellten elektromotorischen Antrieb für die gemäss dem in Fig.2 dargestellten Koordinatensystem K in der Ebene in Pfeilrichtung X und Y orientierte Verstellbewegung versehen.
Die Deckenwandung 211′ wird, wie in Fig.17 dargestellt, ebenfalls von im Abstand zueinander angeordneten Ausnehmungen 227,227′,227˝,228,229,229′ und 229˝ durchdrungen. Die nicht näher bezeichnete Aussenfläche der Deckenwandung 211′ ist zur Aufnahme des Auslegers 300 (Fig.15) ausgebildet, welcher mit nicht dargestellten Befestigungsmitteln lösbar auf dem Trägerelement 290 befestigt ist.
Die in der vertikalen Wand 213 sowie in der Deckenwandung 211′ vorgesehenen Ausnehmungen 220,222,224 und 227,227′, 227˝,228,229,229′,229˝ dienen der Montage und Bedienbarkeit der einzelnen, wesentlichen Teile 150 oder 150′,25 und 260 und gewährleistet unter Beibehaltung der Stabilität weiterhin eine wesentliche und für die freischwebende Verstellbarkeit vorteilhafte Gewichtsreduktion des Trägerelements 290.
Die der zweiten Wand 213′ gegenüberliegende erste Wand 212′ ist an der Innenseite 212˝ mit einer abgesetzt ausgebildeten Ausnehmung 217 (Fig.16) versehen, in welcher das Lagerteil 218 für den Achszapfen 265′ des Kontaktierorgans 150 oder 150′ angeordnet ist. Die nicht näher bezeichnete Aussenfläche der ersten Wand 212′ ist als absolut ebene, vorzugsweise geschliffene Fläche ausgebildet und dient als sogenannte Luftlager-Anlagefläche eines nicht dargestellten, mit dem Trägerelement 290 in Wirkverbindung stehenden und mit nicht dargestellten Mitteln betätigbaren Schiebeteils.

In Fig.18 ist der einer nicht dargestellten Gleitplatte zugewandte Boden 210′ des Trägerelements 290 dargestellt, welcher Boden 210′ vorzugsweise mit einem sogenannten Luftkissenlager vakuumvorgespannt mit der nicht dargestellten Gleitplatte in Wirkverbindung steht und etwa in horizontaler Ebene frei schwebend beweglich ist. Der Boden 210′ weist eine vollumfängliche Druckzone 230 auf und ist mit einer ersten in bezug auf die Druckzone 230 nach innen, in die Bodenwandung gerichteten Ausnehmung 231 sowie mit einer zweiten, in bezug zu der ersten Ausnehmung 231 nach innen gerichteten Ausnehmung 232 versehen. Etwa im mittleren Bereich der zweiten Ausnehmung 232 ist ein Auflageteil 233 vorgesehen. Die Ausnehmung 231 dient zur Aufnahme eines nicht dargestellten und nicht näher bezeichneten, plattenartigen Messelementes, beispielsweise eines an sich bekannten Glas-Massstabes mit entsprechend angeordneten und orientierten Stricheinheiten.
Im Bereich der Druckzone 230 ist in der Bodenwandung 210′, wie in Fig.18 in Draufsicht dargestellt, ein aus Kanälen 235, 235′ und 236,236′ sowie mehreren im Abstand zueinander angeordneten Bohrungen 237 (nur einmal bezeichnet) gebildetes Kanalsystem angeordnet. Die von der Aussenfläche der Druckzone 230 ausgehenden Bohrungen münden in die jeweiligen, aussenseitig mit nicht näher dargestellten und bezeichneten Anschlüssen versehenen Kanäle 235,235′ oder 236,236′.
An dieser Stelle sei darauf hingewiesen, dass die Schiebebewegung des mit den Teilen 260,25,150 oder 150′ und 300 eine Baueinheit bildenden Trägerelementes 290 im wesentlichen mittels der an den Seiten 212,213 und 216 wirkenden, nicht dargestellten Antriebe etwa gemäss dem in Fig.2,16 dargestellten Koordinatensystem K in Pfeilrichtung X und Y erfolgt. Die besondere Ausbildung des Trägerelements 290 in Verbindung mit der Anordnung und Lagerung des im wesentlichen als sogenannte Wippe ausgebildeten Kontaktierorgans 150 oder 150′ im Inneren des Trägerelements 290, der entsprechend ausgebildeten und mit elektromotorischen Antrieben (nicht dargestellt) oder mit einem von entsprechenden Mitteln betätigbares Schiebeteil in Wirkverbindung stehenden Seitenwände 212,213 und Rückseite 216 sowie in Verbindung mit dem vakuumvorgespannt mit einer Gleitplatte (nicht dargestellt) in Wirkverbindung stehenden Boden 210 gewährleistet den Antrieb der gesamten Einrichtung 200 im Schwerpunkt der zu bewegenden Masse, so dass keine Kippmomente am eigentlichen Trägerelement 290 entstehen und eine hochdynamische Zustellbewegung der Einrichtung 200 zu einer Arbeitsstation (nicht dargestellt) gewährleistet ist.

## Patentansprüche

1. Vorrichtung zur ultraschallkontaktierenden Drahtverbindung von Schaltkreisen an elektronischen Komponenten mittels eines Kontaktierorgans (150;150'), welches einen von einem elektromotorischen Antrieb (25) um eine Achse (Z) schwenkbaren ersten Tragrahmen (10;10') sowie einen daran angeordneten und zur Aufnahme eines mit einer Kapillare versehenen Energie-Transducers (175;175') ausgebildeten zweiten Tragrahmen (50;50') umfasst, wobei der zweite Tragrahmen (50;50') an einer im Abstand (D) zur Achse (Z) angeordneten Gelenkstelle (Z') des ersten Tragrahmens gelagert und beim Kontakt der Kapillare (177;177') mit der jeweiligen elektronischen Komponente (170) relativ zum ersten Tragrahmen (10;10') beweglich ist, dadurch gekennzeichnet, dass die beiden Tragrahmen (10, 50;10',50') sowie der Energie-Transducer (175;175') in einem Trägerelement (290) um die Achse (Z) schwenkbar angeordnet sind und einen gemeinsamen, auf der Symmetrieachse (S) der einzelnen Teile liegenden Massenschwerpunkt (M) aufweisen, und dass der Massenschwerpunkt (M) innerhalb eines senkrecht zur Achse (Z) orientierten und mit seinem Zentrum (F) auf einer zwischen der Achse (Z) und der Gelenkstelle (Z') gebildeten und ebenfalls senkrecht zur Achse (Z) orientierten Geraden angeordneten Kreises (E) liegt, dessen Radius (R) kleiner als die Hälfte (R < D/2) des Abstandes (D) zwischen der Achse (Z) und der Gelenkstelle (Z') ist.

2. Vorrichtung nach Anspruch 1, dadurch gekennzeichnet, dass an den Tragrahmen (10,50;10',50') jeweils eine Kontaktvorrichtung (70;70') angeordnet ist, welche zur Bildung bewegungs- und/oder kraftabhängiger Signale für den Energie-Transducer (175;175') ausgebildet ist.

3. Vorrichtung nach den Ansprüchen 1 und 2, dadurch gekennzeichnet, dass dem Kontaktierorgan (150) eine erste Auswerteeinheit (180) zum Erfassen und Verarbeiten bewegungsabhängiger Signale (S1) des Energie-Transducers (175) sowie eine erste Regeleinheit (185) zur Bildung abhängiger elektrischer Signale (S3) für die Betätigung des elektromotorischen Antriebs (25) zugeordnet sind.

4. Vorrichtung nach den Ansprüchen 1 bis 3, dadurch gekennzeichnet, dass dem Kontaktierorgan (150') die erste Auswerteeinheit (180) für die bewegungsabhängigen Signale (S1) des Energie-Transducers (175') und die erste Regeleinheit (185) für die elektrischen Signale (S3) sowie eine zweite Auswerteeinheit (184) zum Erfassen und Verarbeiten kraftabhängiger Signale (S75,S75';S77,S77') des Energie-Transducers (175') und eine zweite Regeleinheit (186) zur Bildung weiterer elektrischer Signale für die Betätigung des elektromotorischen Antriebs (25) zugeordnet sind.

5. Vorrichtung nach Anspruch 2, dadurch gekennzeichnet, dass die Kontaktvorrichtung (70') für das Kontaktierorgan (150') zu beiden Seiten des Energie-Transducers (175') je mindestens ein am Tragrahmen (50') angeordnetes und mit einer Leiterplatte (76,76') elektrisch in Verbindung stehendes Piezo-Element (75,75') aufweist, von welchem bei der in Pfeilrichtung (Z'') orientierten Schwenkbewegung des Energie-Transducers kraftabhängige Signale erfassbar sind.

6. Vorrichtung nach den Ansprüchen 2 und 5, dadurch gekennzeichnet, dass die Kontaktvorrichtung (70') zu beiden Seiten der Längs- oder Symmetrieachse (S) des Transducers (175') je eine Leiterplatte (76,76') aufweist, und dass die einzelne, an Auflageteilen (59,59') des Tragrahmens (50') befestigte Leiterplatte (76,76') jeweils zur Aufnahme und elektrischen Verbindung von zwei Piezo-Elementen (75,77;75',77') ausgebildet ist, wobei die Piezo-Elemente (75,77;75',77') in Bezug zu der im wesentlichen durch ein am Tragrahmen (50') angeordnetes Klemmteil (55) gebildeten Gelenkstelle (Z') im Abstand zueinander angeordnet sind.

7. Vorrichtung nach Anspruch 6, dadurch gekennzeichnet, dass die Piezo-Elemente (75,77;75',77') in Bezug zu der Längs- oder Symmetrieachse (S) des Energie-Transducers (175') sowie in Bezug zu der Gelenkstelle (Z') symmetrisch zueinander auf den Leiterplatten (76,76') angeordnet und befestigt sind.

8. Vorrichtung nach Anspruch 1, dadurch gekennzeichnet, dass der auf der Symmetrieachse (S) liegende und mit entsprechenden Mitteln rechnerisch zu bestimmende Massenschwerpunkt (M) der beiden Tragrahmen (10,50;10',50') und des daran angeordneten Energie-Transducers (175;175') innerhalb des oberen Halbkreises (E') des Kreises (E) angeordnet ist.

9. Vorrichtung nach Anspruch 1, dadurch gekennzeichnet, dass der erste Tragrahmen (10;10') in seinem vorderen Bereich zur Aufnahme und Befestigung einer Draht-Klemmvorrichtung (35) ausgebildet ist, welche zwei an einer etwa aus einer Blattfeder (39) gebildeten Gelenkstelle miteinander wirkverbundene und gegen die Rückstellkraft einer Feder (46) von einem zugeordneten Elektromagneten (36) betätigbare und im vorderen Bereich mit Klemmplättchen (42,43) versehene Klemmstücke (40, 45) aufweist.

10. Vorrichtung nach Anspruch 1, dadurch gekennzeichnet, dass die Relativbewegung des zweiten Tragrahmens (50) in Bezug auf den ersten Tragrahmen (10) durch eine Justiervorrichtung (60) einstellbar ist, und dass die Justiervorrichtung (60) beidseitig auf den zweiten Tragrahmen (50) wirkende Druckfeder (63,64) aufweist, welche in ihrer Federkraft einstellbar sind.

11. Vorrichtung nach Anspruch 1, dadurch gekennzeichnet, dass der an dem einen Ende zur schwenkbaren Lagerung des zweiten Tragrahmens (50;50') ausgebildete erste Tragrahmen (10;10') an dem anderen Ende einen Magnetkörper (20) aufweist, welcher in einem durch zwei im Abstand zueinander angeordnete Statorkörper (26,26') und Spulenkörper (33,33') gebildeten Spalt (27) des elektromotorischen Antriebs (25) angeordnet ist, und der Magnetkörper (20) bei entsprechender Erregung der Spulenkörper (33,33') zusammen mit dem Tragrahmen (10;10') um die quer zur Bewegungsrichtung (Z'') orientierte Achse (Z) um einige Winkelgrade nach oben und unten begrenzt schwenkbar ist.

12. Vorrichtung nach Anspruch 1, dadurch gekennzeichnet, dass das Kontaktierorgan (150;150'), welches im wesentlichen den ersten Tragrahmen (10;10') mit dem Magnetkörper (20), den elektromotorischen Antrieb (25), die Klemmvorrichtung (35) sowie den zweiten Tragrahmen (50;50') mit dem Energie-Transducer (175;175') umfasst, als eine in das Trägerelement (290) einbaubare und in der Ebene frei verstellbare Funktionseinheit ausgebildet ist.

13. Vorrichtung nach Anspruch 1 und 12, dadurch gekennzeichnet, dass das Trägerelement (290) als einstückige, durch eine obere Deckenwandung (211'), einen unteren Boden (210') sowie diese miteinander verbindende Wände (212',213') gebildete starre, gehäuseartige Zellenkonstruktion in Form eines quaderförmigen Hohlkörpers mit Kammern (225,224) zur Aufnahme und schwenkbaren Lagerung des aus den einzelnen Elementen gebildeten Kontaktierorgans (150;150') und des damit wirkverbundenen elektromotorischen Antriebs (25) sowie eines Drehgebers (260) ausgebildet ist, und dass die Unterseite (210) des Trägerelements (290) als ein vakuumvorspannbares Luftkissenlager ausgebildet ist, welches eine vollumfänglich von einer Druckzone (230) umgebenen Vakuumzone (231,232) aufweist.

## Claims

1. A device for the wire connection, in an ultrasonic-contacting manner, of switching circuits to electronic components by means of a contacting element (150; 150'), which element comprises a first supporting frame (10; 10') able to be pivoted by an electric motor drive (25) about an axis (Z), as well as a second supporting frame (50; 50') arranged thereon and formed for receiving an energy transducer (175; 175'), provided with a capillary, wherein the second supporting frame (50; 50') is mounted on a pivot point (Z') of the first supporting frame, arranged at a distance (D) to the axis (Z), and, with contact of the capillary (177; 177') with the respective electronic component (170) is able to be moved relative to the first supporting frame (10; 10'), characterised in that the two supporting frames (10, 50; 10', 50') as well as the energy transducer (175; 175') are arranged in a support element (290) so as to be pivoted about the axis (Z) and have a common centre of gravity (M) lying on the axis of symmetry (S) of the individual parts, and in that the centre of gravity (M) lies within a circle (E) orientated perpendicularly towards the axis (Z) and arranged with its centre (F) on a straight line formed between the axis (Z) and the pivot point (Z') and also orientated perpendicularly to the axis (Z), the radius (R) of which circle is smaller than half (R < D/2) of the spacing (D) between the axis (Z) and the pivot point (Z').

2. A device according to claim 1,
characterised in that arranged in each case on the supporting frame (10, 50; 10', 50') there is a contact device (70; 70') which is designed to form signals, which are dependent on movement and force, for the energy transducer (175; 175').

3. A device according to claims 1 and 2,
characterised in that a first evaluating unit (180) for detecting and processing movement-dependent signals (S1) of the energy transducer (175), as well as a first regulating unit (185) for forming dependent electric signals (S3) for the activation of the electric motor drive (25) are associated with the contacting element (150).

4. A device according to claims 1 to 3,
characterised in that the first evaluating unit (180) for the movement-dependent signals (S1) of the energy transducer (175'), and the first regulating unit (185) for the electric signals (S3) as well as a second evaluating unit (184) for detecting and processing force-dependent signals (S75, S75'; S77, S77') of the energy transducer (175'), and a second regulating unit (186) for forming further electric signals for the activation of the electric motor drive (25) are associated with the contacting element (150').

5. A device according to claim 2,
characterised in that the contact device (70') for the contacting element (150') has at both sides of the energy transducer (175') in each case at least one piezo-element (75, 75') arranged on the supporting frame (50') and electrically connected to a printed board (76, 76'), with which force-dependent signals are able to be detected when there is pivoting movement of the energy transducer orientated in the direction of the arrow (Z'').

6. A device according to claims 2 and 5,
characterised in that the contact device (70') has at both sides of the longitudinal axis or axis of symmetry (S) of the transducer (175') a respective printed board (76, 76') and in that the individual printed board (76, 76') secured to bearing parts (59, 59') of the supporting frame (50') is formed in each case for receiving and for electrical connection of two piezo-elements (75, 77; 75', 77'), wherein the piezo-elements (75, 77; 75', 77') are arranged spaced from each other, relative to the pivot point (Z') formed substantially by a clamping part (55) arranged on the supporting frame (50').

7. A device according to claim 6,
characterised in that the piezo-elements (75, 77; 75', 77') are arranged and secured on the printed boards (76, 76') symmetrically relative to each other and relative to the longitudinal axis or axis of symmetry (S) of the energy transducer (175'), as well as relative to the pivot point (Z').

8. A device according to claim 1,
characterised in that the centre of gravity (M) of the two supporting frames (10, 50; 10', 50') and of the energy transducer (175; 175'), arranged thereon, which centre of gravity lies on the axis of symmetry (S) and is to be determined arithmetically with corresponding means, is arranged within the upper semi-circle (E') of the circle (E).

9. A device according to claim 1,
characterised in that the first supporting frame (10; 10') is formed in its front region for receiving and securing a wire-clamping device (35), which has two clamping pieces (40, 45) which are operatively connected to each other at a pivot point, formed approximately of a plate spring (39), and able to be activated, against the restoring force of a spring (46), by an associated electric magnet (36), and provided in the front region with small clamping plates (42, 43).

10. A device according to claim 1,
characterised in that the relative motion of the second supporting frame (50) is able to be adjusted relative to the first supporting frame (10) by an adjusting device (60), and in that the adjusting device (60) has compression springs acting on both sides of the second supporting frame (50), which are able to be adjusted in their spring tension.

11. A device according to claim 1,
characterised in that the first supporting frame (10, 10'), formed on the one end for pivotable bearing of the second supporting frame (50; 50'), has on the other end a magnetic body (20), which is arranged in a gap (27) of the electric motor drive (25) formed by two (bodies), a stator body (26, 26') and a coil form (33, 33'), arranged spaced from each other, and the magnetic body (20) is able to be pivoted by some degrees of angle with the supporting frame (10; 10') about the axis (Z), orientated transverse to the direction of motion (Z''), upwards and downwards in a limited manner.

12. A device according to claim 1,
characterised in that the contacting element (150; 150'), which comprises substantially the first supporting frame (10; 10') with the magnetic body (20), the electric motor drive (25), the clamping device (35) and the second supporting frame (50; 50') with the energy transducer (175; 175'), is formed as a function unit able to be incorporated into the support element (290) and able to be freely adjustable in the plane.

13. A device according to claim 1 and 12,
characterised in that the support element (290) is formed as a rigid housing-like cell construction, formed in one piece by an upper overhead wall (211'), a lower base (210') as well as walls (212', 213') connecting these to each other, in the form of a square hollow body with chambers (225, 224), for receiving and for pivotable bearing of the contacting element (150; 150') formed from the individual elements and of the electric motor drive (25) operatively connected thereto, as well as an encoder (260), and in that the lower side (210) of the support element (290) is formed as a vacuum-prestressing air cushion bearing which has a vacuum zone (231, 232) surrounded completely and the circumference by a pressure zone (230).

## Revendications

1. Dispositif pour la liaison par fil, par mise en contact par ultrasons, de circuits de commutation sur des composants électroniques au moyen d'un organe de mise en contact (150; 150') qui comporte un premier châssis porteur (10; 10'), qui peut être pivoté autour d'un axe (Z) par une commande (25) à moteur électrique, et un second châssis porteur (50; 50') qui y est agencé et qui est réalisé pour le logement d'un transducteur d'énergie (175; 175') muni d'un capillaire, le second châssis porteur (50; 50') étant monté en un endroit d'articulation (Z'), du premier châssis porteur, agencé à la distance (D) de l'axe (Z) et étant mobile par rapport au premier châssis porteur (10; 10') lors du contact du capillaire (177; 177') et des composants électriques respectifs, caractérisé en ce que les deux châssis (10, 50; 10', 50') ainsi que le transducteur d'énergie (175; 175') sont agencés de façon pivotante autour de l'axe (Z), dans un élément porteur (290), et présentent un centre de gravité de masse commun (M) situé sur l'axe de symétrie (S) des éléments séparés et en ce que le centre de gravité de masse (M) est situé dans un cercle (E) qui est orienté perpendiculairement à l'axe (Z), qui est agencé avec son centre (F) sur une droite formée entre l'axe (Z) et l'endroit d'articulation (Z') et orientée également perpendiculairement à l'axe (Z), et dont le rayon (R) est inférieur à la moitié (R < D/2) de la distance (D) entre l'axe Z et l'endroit d'articulation (Z').

2. Dispositif suivant la revendication 1, caractérisé en ce que sur les châssis porteurs (10, 50; 10', 50') est chaque fois agencé un dispositif de mise en contact (70; 70') qui est réalisé pour la formation de signaux, dépendant du mouvement et/ou de la force, pour le transducteur d'énergie (175; 175').

3. Dispositif suivant l'une ou l'autre des revendications 1 et 2, caractérisé en ce qu'à l'organe de mise en contact (150) sont adjoints une première unité d'évaluation (180) pour la saisie et le traitement de signaux (S1), dépendant du mouvement, du transducteur d'énergie (175) et une première unité de réglage (185) pour la formation de signaux électriques dépendants (S3) pour l'actionnement de la commande à moteur électrique (25).

4. Dispositif suivant l'une quelconque des revendications 1 à 3, caractérisé en ce qu'à l'organe de mise en contact (150') sont adjoints la première unité d'évaluation (180) pour les signaux (S1), dépendant du mouvement, du transducteur d'énergie (175') et la première unité de réglage (185) pour les signaux électriques (S3) ainsi qu'une seconde unité d'évaluation (184) pour la saisie et 1e traitement de signaux (S75, S75'; S77, S77'), dépendant de la force, du transducteur d'énergie (175') et une seconde unité de réglage (186) pour la formation d'autres signaux électriques en vue de l'actionnement de la commande à moteur électrique (25).

5. Dispositif suivant la revendication 2, caractérisé en ce que le dispositif de mise en contact (70') présente pour l'organe de mise en contact (150'), des deux côtés du transducteur d'énergie (175'), chaque fois au moins un élément piézoélectrique (75, 75') qui est agencé sur le châssis porteur (50'), qui est électriquement en liaison avec un circuit imprimé (76, 76') et dont des signaux dépendant de la force peuvent être saisis lors du mouvement de pivotement, orienté dans la direction des flèches (Z''), du transducteur d'énergie.

6. Dispositif suivant l'une ou l'autre des revendications 2 et 5, caractérisé en ce que le dispositif de mise en contact (70') présente chaque fois un circuit imprimé (76, 76') des deux côtés de l'axe longitudinal ou de symétrie (S) du transducteur (175') et en ce que le circuit imprimé (76, 76') séparé fixé sur des éléments porteurs (59, 59') du châssis porteur (50') est réalisé chaque fois pour le logement et pour la liaison électrique de deux éléments piézoélectriques (75, 77; 75', 77'), les éléments piézoélectriques (75, 77; 75', 77') étant agencés à distance l'un de l'autre par rapport à l'endroit d'articulation (Z') formé essentiellement par un élément de serrage (55) agencé sur le châssis porteur (50').

7. Dispositif suivant la revendication 6, caractérisé en ce que les éléments piézoélectriques (75, 77; 75', 77') sont agencés et fixés symétriquement l'un par rapport à l'autre sur les circuits imprimés (76, 76') par rapport à l'axe longitudinal ou de symétrie (S) du transducteur d'énergie (175') ainsi que par rapport à l'endroit d'articulation (Z').

8. Dispositif suivant la revendication 1, caractérisé en ce que le centre de gravité de masse (M), des deux châssis porteurs (10, 50; 10', 50') et du transducteur d'énergie (175; 175') qui y est agencé, situé sur l'axe de symétrie (S) et à déterminer par calcul avec des moyens correspondants est agencé dans le demi-cercle supérieur (E') du cercle (E).

9. Dispositif suivant la revendication 1, caractérisé en ce que le premier châssis porteur (10; 10') est réalisé, dans sa zone antérieure, pour le logement et la fixation d'un dispositif de serrage de fil (35) qui présente deux éléments de serrage (40, 45) reliés l'un à l'autre de façon active en un endroit d'articulation formé approximativement par un ressort à lame (39), actionnables par des électroaimants (36) adjoints, contre la force de rappel d'un ressort (46), et munis dans la zone antérieure de plaquettes de serrage (42, 43).

10. Dispositif suivant la revendication 1, caractérisé en ce que le mouvement relatif du second châssis porteur (50) par rapport au premier châssis porteur (10) peut être réglé par un dispositif d'ajustage (60) et en ce que le dispositif d'ajustage (60) présente des deux côtés des ressorts de compression (63, 64) qui agissent sur le second châssis porteur (50) et qui sont réglables quant à leur force de ressort.

11. Dispositif suivant la revendication 1, caractérisé en ce que le premier châssis porteur (10; 10') réalisé à l'une des extrémités pour le montage pivotant du second châssis porteur (50; 50') présente à l'autre extrémité un corps d'aimant (20) qui est agencé dans un interstice (27), de la commande à moteur électrique (25), formé par deux corps de stator (26, 26') et corps de bobinage (33, 33') agencés à distance l'un de l'autre et en ce que le corps d'aimant (20) peut être pivoté de façon limitée vers le haut et vers le bas, lors d'une excitation correspondante des corps de bobinage (33, 33'), avec le châssis porteur (10; 10') de quelques degrés d'angle autour de l'axe (Z) orienté transversalement à la direction de mouvement (Z').

12. Dispositif suivant la revendication 1, caractérisé en ce que l'organe de mise en contact (150; 150'), qui comporte essentiellement le premier châssis porteur (10; 10') avec le corps d'aimant (20), avec la commande par moteur électrique (25), et avec le dispositif de serrage (35) ainsi que le second châssis porteur (50; 50') avec le transducteur d'énergie (175; 175'), est réalisé sous la forme d'une unité fonctionnelle qui peut être montée dans l'élément porteur (290) et qui peut être réglée librement dans le plan.

13. Dispositif suivant l'une ou l'autre des revendications 1 et 12, caractérisé en ce que l'élément porteur (290) est réalisé sous la forme d'une construction de cellule, en une pièce, rigide, en genre de boîtier, qui est formée par une paroi de couverture (211') par un fond inférieur (210') ainsi que par des parois (212', 213') reliant l'une à l'autre ces pièces et qui a la forme d'un corps creux parallélépipédique comportant des chambres (225, 224) pour le logement et le montage pivotant de l'organe de mise en contact (150; 150'), formé par les éléments séparés, de la commande (25) à moteur électrique qui y est reliée ainsi que d'un détecteur de rotation (260), et en ce que le côté inférieur (210) de l'élément porteur (290) est réalisé sous la forme d'un palier à coussin d'air qui peut être précontraint par du vide et qui présente une zone à vide (231, 232) entourée sur le pourtour complet par une zone à pression (230).
